# FASCICULE DE BREVET EUROPEEN

(11) **EP 2 452 369 B1**
(45) Date de publication et mention de la délivrance du brevet: **04.11.2020**
(21) Numéro de dépôt: 10740342.0
(22) Date de dépôt: 07.07.2010
(51) Int. Cl.: H01L 31/043, H01L 31/02

(54) **PROCÉDÉ DE FABRICATION DE CELLULES PHOTOVOLTAIQUES MULTI-JONCTIONS ET MULTI-ÉLECTRODES**
VERFAHREN ZUR HERSTELLUNG VON PV-ZELLEN MIT MEHREREN ANSCHLÜSSEN UND MEHREREN ELEKTRODEN
METHOD FOR MANUFACTURING PHOTOVOLTAIC CELLS WITH MULTIPLE JUNCTIONS AND MULTIPLE ELECTRODES

(30) Priorité: 08.07.2009 FR 0903376
(43) Date de publication de la demande: 16.05.2012
(73) Titulaire: TOTAL MARKETING SERVICES, 92800 Puteaux (FR)
(72) Inventeur: VERMEERSCH, Marc, 78110 Le Vésinet (FR); FRANCKE, Loïc, 92000 Nanterre (FR)
(74) Mandataire: Croonenbroek, Thomas Jakob
(86) Numéro de dépôt international: PCT/IB2010/053107
(87) Numéro de publication internationale: WO 2011/004329

(56) Documents cités:
- EP-A2- 2 065 942
- WO-A1-03/100868
- WO-A1-2008/059593
- WO-A1-2008/091098
- FR-A1- 2 837 625

## Description

### DOMAINE TECHNIQUE

La présente invention concerne le domaine des dispositifs photovoltaïques et plus particulièrement les dispositifs multi-jonctions comprenant des cellules dites tandem. L'invention concerne la fabrication de dispositifs photovoltaïques à cellules multi-électrodes dans lesquels plusieurs cellules photovoltaïques déposées sur des substrats indépendants sont associées pour fabriquer un module photovoltaïque multi-électrodes qui permette un accès direct à l'ensemble des électrodes et qui prévienne le risque de court-circuit entre ces électrodes.

### ETAT DE LA TECHNIQUE

De manière connue en soi, un générateur photovoltaïque (GPV) comprend une pluralité de cellules photovoltaïques (PV) reliées en série et/ou en parallèle. Une cellule photovoltaïque est une diode (jonction PN ou PIN) semi-conductrice conçue pour absorber de l'énergie lumineuse et la convertir en énergie électrique. Lorsque des photons sont absorbés par le semi-conducteur, ils transmettent leur énergie aux atomes de la jonction PN de telle sorte que les électrons de ces atomes se libèrent et créent des électrons libres (charges N) et des trous (charges P). Une différence de potentiel apparaît alors entre les deux couches (P et N) de la jonction ; cette différence de potentiel est mesurable entre les bornes positive et négative de la cellule. La tension maximale d'une cellule est typiquement d'environ 0,6 V pour un courant nul (circuit ouvert) et le courant maximal pouvant être fourni par la cellule dépend fortement du niveau d'ensoleillement de la cellule.

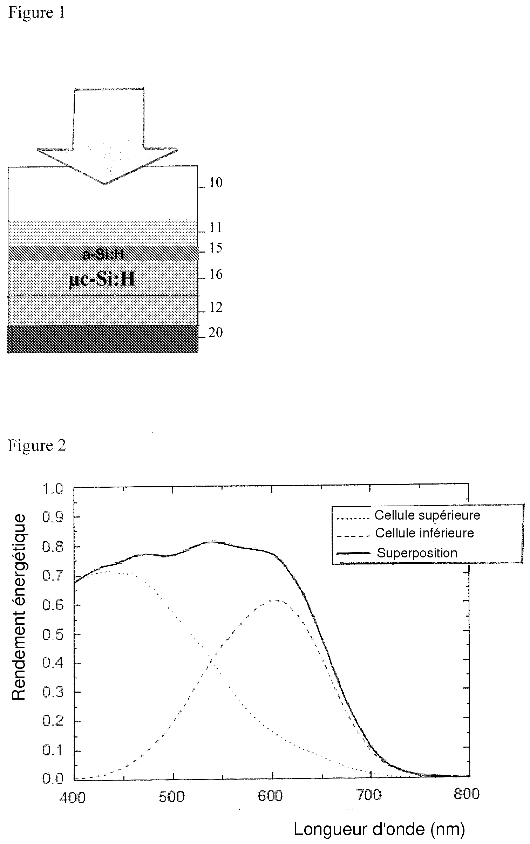

Une cellule photovoltaïque à jonctions tandem désigne une multi-jonction constituée de deux jonctions simples empilées l'une sur l'autre de façon à accroître la zone d'absorption de spectre solaire par la cellule. Selon les technologies, les deux jonctions peuvent être en contact direct l'une de l'autre ou en contact indirect avec une couche intermédiaire d'oxyde transparent conducteur. Dans ce dernier cas, l'oxyde transparent conducteur intercalé entre les deux jonctions a un rôle de réflecteur intermédiaire pour accroître le trajet optique de la lumière par réflexions multiples. La figure 1 montre schématiquement une cellule tandem composée d'une première jonction en silicium amorphe (a-Si:H) et d'une seconde jonction en silicium microcristallin (µc-Si:H) à contact direct en coupe transversale selon le trajet de la lumière incidente. Les proportions en épaisseur des différentes couches ne sont pas respectées sur le schéma de la figure 1. Les différents matériaux sont déposés en films minces sur un substrat verrier 10 par PVD (Physical Vapor Déposition) ou PECVD (Plasma Enhanced Chemical Vapor Déposition). Sont ainsi successivement déposées, une première électrode transparente conductrice 11, une première jonction PIN simple 15 formant la cellule photovoltaïque frontale, une seconde jonction PIN simple 16 formant la cellule photovoltaïque arrière, une seconde électrode transparente conductrice 12 et un réflecteur arrière 20. Pour des raisons pratiques de fabrication, les architectures des cellules tandem sont aujourd'hui principalement réalisées en technologie dite films minces, que ceux-ci soit inorganiques, organiques, ou hybrides (inorganique/organique). Dans la technologie des films minces, la superposition physique des cellules photovoltaïques est obtenue par des séquences adéquates de dépôts successifs des électrodes 11, 12 destinées à collecter le courant produit et des couches actives 15, 16.

Les cellules tandem constituent une avancée technologique significative dans le domaine des dispositifs photovoltaïques, principalement en ce qui concerne leur rendement de conversion électrique. En effet, réaliser une architecture tandem consiste à superposer physiquement (par rapport au sens supposé de la lumière incidente) deux cellules photovoltaïques dont les zones d'absorption optique respectives sont décalées en énergie. Le couplage optique des cellules confère à l'ensemble (i.e. le tandem) une zone d'absorption globale supérieure à celle des cellules séparées. Le rendement de conversion électrique s'en retrouve augmenté pour peu que cette absorption optique puisse être convertie et valorisée en énergie électrique.

La figure 2 est un graphique illustrant le rendement de conversion exprimé en % d'une cellule tandem en couches minces de silicium. Les zones d'absorption respectives des cellules superposées (« cellule supérieure » pour la cellule avant et « cellule inférieure » pour la cellule arrière) et la zone d'absorption globale de la cellule (« superposition ») sont représentées. La technologie des cellules tandem constitue une solution pour augmenter les performances énergétiques des générateurs photovoltaïques. Différentes architectures de cellules tandem ont ainsi été développées ces dernières années. On peut se référer par exemple aux documents EP-A-1 906 457, US-A-2008/0023059 ou WO 2004/112161. Ces documents proposent chacun différents assemblages de matériaux photovoltaïques visant à accroître l'absorption d'énergie de l'ensemble.

Les cellules tandem décrites ci-dessus sont caractérisées par un double couplage : un couplage optique du fait de l'empilement de cellules photovoltaïques actives dans des zones différentes du spectre solaire ; et un couplage électrique par contact direct ou indirect des deux jonctions et la présence de deux électrodes aux extrémités du tandem.

L'inconvénient principal du couplage électrique dans une cellule tandem est la nécessité d'un accord des performances des cellules photovoltaïques constituant le tandem, quelles que soient les conditions d'ensoleillement. Ce cas idéal n'est pas accessible dans la réalité car la production de courant de chaque cellule est volontairement différente suivant la région du spectre où elles sont actives et varie en fonction des conditions d'ensoleillement. Il est résulte une limitation intrinsèque de la cellule tandem par le plus faible de ses éléments. Une telle limitation en courant réduit fortement le rendement théorique d'une cellule tandem.

Il a donc été proposé de découpler électriquement les jonctions d'une cellule tandem. Les cellules photovoltaïques du tandem sont toujours couplées optiquement mais sont découplées électriquement. Chaque jonction est associée à deux électrodes électriques ; on obtient ainsi une cellule photovoltaïque tandem à quatre électrodes, deux électrodes pour chacune des deux jonctions du tandem. Une couche de matériau transparent à la lumière et électriquement isolant est insérée entre les électrodes des jonctions adjacentes.

Les électrodes de la cellule tandem sont en général reliées électriquement par l'intermédiaire de bornes de sortie de courant au niveau d'un boîtier de connexion, à un dispositif électronique permettant de convertir une tension continue en une tension alternative compatible avec le réseau de distribution. Ce dispositif permet également de contrôler l'ensemble des cellules photovoltaïques ou bien contrôler de façon indépendante chacune des cellules. Les deux bornes de sortie de courant d'une cellule photovoltaïque sont en général situées soit sur des bords opposés de la cellule photovoltaïque au niveau de deux boîtiers de connexion, soit au niveau de la médiane de la cellule au niveau d'un boîtier unique de connexion. La Figure 1 du document US 4,461,922 décrit deux cellules tandems superposées formant un module, dans lequel les bornes de sortie de courant sont situées sur des bords opposés du module. Le contrôle du module nécessite donc de disposer sur des faces opposées du module deux boîtiers de connexion. Cette disposition des boîtiers de connexion sur des bords opposés du module a pour inconvénient de rendre volumineux l'ensemble constitué par le module et les boîtiers de connexion.

D'autre part, lorsque l'on superpose directement deux cellules photovoltaïques identiques, les bornes de sortie de courant ne sont séparées que d'une distance très faible, par exemple égale à l'épaisseur de la couche de matériau isolant transparent à la lumière, intercalée entre deux cellules photovoltaïques adjacentes. Cette épaisseur est de l'ordre du millimètre voire moins. La superposition de ces cellules photovoltaïques implique donc la superposition des rubans de contact électrique de chacune des deux cellules et le risque de courts-circuits au sein de la cellule photovoltaïque 4-fils formée. D'autre part, l'accès aux électrodes est rendu difficile en raison du faible écart séparant les électrodes d'une même polarité situées sur deux cellules photovoltaïques adjacentes. Il est donc difficile de les connecter à un boîtier de connexion. Le document FR2837625 décrit également un dispositif photovoltaïque multi-jonctions contacté en face avant et/ou arrière par des puits métallisés.

Il existe donc un besoin pour un dispositif photovoltaïque multi-jonctions et multi-terminaux dans lequel le risque de court-circuit entre les rubans collecteurs de courant de chacune des cellules soit le plus réduit possible et pouvant être contrôlé par un seul boîtier de connexion. En particulier, il existe un besoin pour un procédé de fabrication d'un dispositif photovoltaïque multi-jonctions qui rende plus aisée la connexion des bornes de sortie de courant de chaque cellule photovoltaïque au boîtier de connexion.

A cet effet, l'invention propose un dispositif photovoltaïque tel que définit dans les revendications

D'autres caractéristiques et avantages de l'invention apparaîtront à la lecture de la description, donnéé à titre d'exemple et en référence aux dessins annexés, qui montrent :
- figure 1, déjà décrite, une cellule photovoltaïque à jonctions tandem de l'art antérieur ;
- figure 2, déjà décrite, un graphe de rendement énergétique d'une cellule photovoltaïque à jonctions tandem de l'art antérieur ;
- figure 3, un schéma d'une cellule photovoltaïque à jonctions tandem ;
- figure 4, une vue schématique de l'assemblage de cellules tandem ;
- figure 5, une description des faces A et B des substrats ;
- figure 6, une description des faces d'une cellule photovoltaïque : la face E est la face d'entrée de la lumière et la face S est la face de sortie de la lumière ;
- figure 7, une vue schématique du câblage électrique du dispositif photovoltaïque ;
- figure 8, une vue schématique de la configuration « électrodes en face arrière » ;
- figure 9, un schéma du principe de câblage ;
- figure 10a : un exemple d'empilement de quatre cellules 2-électrodes en configuration « électrodes sur la tranche » (ou électrodes sur la face latérale) avant assemblage ;
- figure 10b : un exemple d'empilement de quatre cellules 2-électrodes en configuration « électrodes sur la tranche » (ou électrodes sur la face latérale) après assemblage ;
- figure 10c : une vue schématique d'un exemple d'empilement de quatre cellules 2-électrodes en configuration « électrodes sur la tranche » (ou électrodes sur la face latérale) avant assemblage ;
- figure 10d : une vue schématique d'un exemple d'empilement de quatre cellules 2-électrodes en configuration « électrodes sur la tranche » (ou électrodes sur la face latérale) avant assemblage ;
- figure 10e : une vue schématique d'un exemple d'empilement de quatre cellules 2-électrodes en configuration « électrodes sur la tranche » (ou électrodes sur la face latérale) après assemblage ;
- figure 11a : Exemple d'empilement de quatre cellules 2-électrodes en configuration « électrodes en face arrière » avant assemblage ;
- figure 11b : Exemple d'empilement de quatre cellules 2-électrodes en configuration « électrodes en face arrière » après assemblage ;
- figure 11c : Exemple d'empilement de quatre cellules 2-électrodes en configuration « électrodes en face arrière » avant assemblage dans lequel les bornes de sortie de courant sont décentrées par rapport à l'axe de la cellule photovoltaïque ;
- figure 12a : Principe de passage des rallonges de bandes de connexion d'une cellule intermédiaire i (1<i<n) à deux électrodes, placée dans l'empilement de façon à ce que la face E corresponde à la face A et la face S corresponde à la face B, placée dans une cellule multi-jonctions et multi-électrodes en configuration « électrodes en face arrière » ;
- figure 12b : Principe de passage des rallonges de bandes de connexion d'une cellule intermédiaire i (1<i<n) à deux électrodes, placée dans l'empilement de façon à ce que la face E corresponde à la face B et la face S corresponde à la face A placée dans une cellule multi-jonctions et multi-électrodes en configuration « électrodes en face arrière » ;
- figures 13 a) et 13b) représentent une cellule photovoltaïque dont les bornes de sortie de courant sont des contacts aux extrémités des bandes de connexions. Le contact peut être situé soit sur la tranche (ou face latérale) de la cellule photovoltaïque (fig.13a), soit dans un logement situé sur la tranche (ou face latérale) de la cellule photovoltaïque (fig.13b). Des fiches (400, 400') viennent coopérer avec les contacts (500, 500') ;
- figures 14 a) et 14b) représentent une cellule photovoltaïque selon l'invention dont les bornes de sortie de courant sont des contacts aux extrémités des bandes de connexions. Le contact est situé en face arrière de la cellule photovoltaïque (fig.14b). Des fiches (400, 400', 400", 400'") viennent coopérer avec les contacts (500, 500', 500", 500'") en face arrière de la cellule photovoltaïque.

### EXPOSE DETAILLE DES MODES DE REALISATION

Il est exposé un procédé de fabrication d'un dispositif photovoltaïque multi-jonctions et multi-électrodes qui permette d'avoir un accès direct aux deux électrodes de chacune des n cellules photovoltaïques.

On décrit d'abord la structure d'une cellule photovoltaïque à deux jonctions tandem découplées électriquement (quatre électrodes).

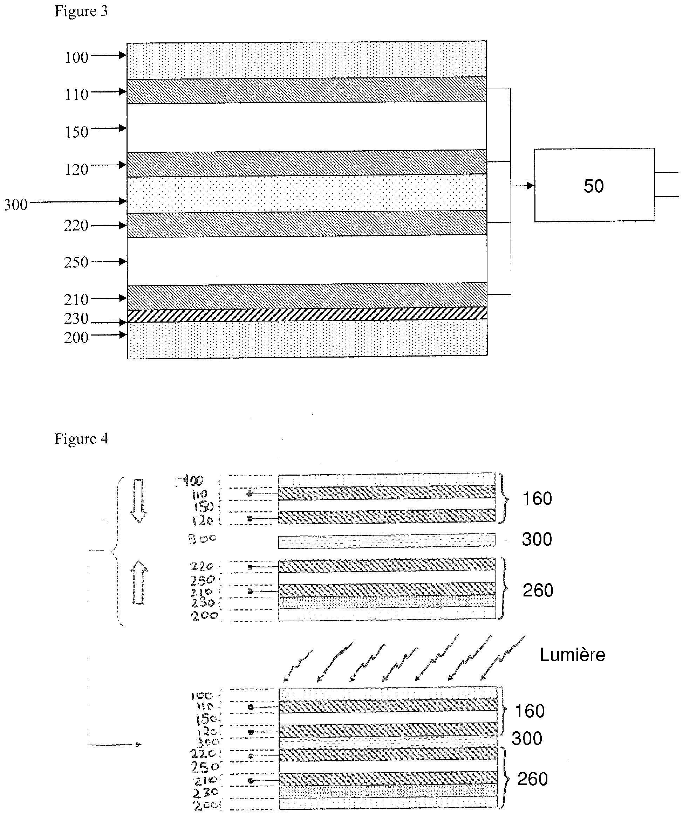

La figure 3 illustre schématiquement une vue en coupe transversale d'une cellule photovoltaïque à jonctions tandem avec quatre électrodes de sortie de courant vers un boîtier de connexion.

La figure 3 montre successivement (du haut vers le bas) un premier substrat 100 supportant une première cellule photovoltaïque comprenant une première électrode 110 et une seconde électrode 120 encadrant une première jonction photovoltaïque 150. Une couche 300 de matériau transparent et isolant électriquement sépare la première cellule photovoltaïque d'une seconde cellule comprenant une première électrode 210 et une seconde électrode 220 encadrant une seconde jonction photovoltaïque 250. Une couche de réflecteur arrière 230 peut être prévue au dessous de la seconde cellule photovoltaïque. La figure 3 montre enfin un second substrat 200. Les électrodes 110, 120, 210 et 220 sont reliées à un boîtier de connexion 50.

La figure 4 illustre schématiquement l'étape d'assemblage de deux cellules photovoltaïques fabriquées séparément. Les cellules 160, 260 sont alors assemblées de part et d'autre d'une couche de résine 300 transparente à la lumière. L'assemblage peut se faire par lamination par exemple.

La figure 3 représente un assemblage limité à deux cellules photovoltaïques mais un module peut comprendre n cellules photovoltaïque, n étant supérieur à 2. Dans un tel cas, on distingue 3 types de cellules photovoltaïques au sein du module :
- la cellule photovoltaïque avant (i=1) qui est la première cellule traversée par les rayons lumineux,
- les cellules photovoltaïques intermédiaires (1<i<n) ;
- la cellule photovoltaïque arrière (i=n) qui reçoit en dernier les rayons lumineux.

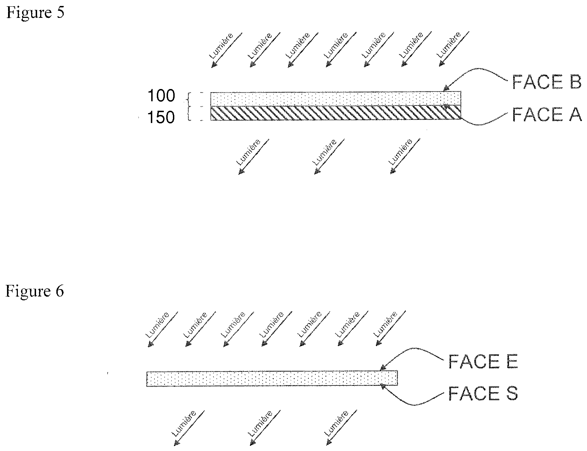

Chaque substrat comporte deux faces (voir figure 5) :
- une face A sur laquelle l'absorbeur d'énergie lumineuse (jonction) est déposé ;
- une face B qui ne présente aucun dépôt spécifique à la conversion photovoltaïque du rayonnement solaire.

Chaque cellule photovoltaïque comporte deux faces (voir figure 6):
- une face d'entrée E sur laquelle arrive le rayonnement solaire ;
- une face de sortie S de laquelle quitte le rayonnement solaire après avoir traversé l'ensemble du substrat et des différentes couches minces ou sur laquelle se réfléchi le rayonnement solaire après avoir traversé l'ensemble du substrat et des différentes couches minces.

L'empilement des cellules indépendantes, est tel que :
- Pour la cellule photovoltaïque avant (i=1) à deux électrodes, la face E correspond à la face B et la face S correspond à la face A ;
- Pour chaque cellule photovoltaïque intermédiaire (1<i<n) à deux électrodes, la face E correspond à la face B et la face S correspond à la face A ;
- Pour la cellule photovoltaïque arrière (i=n) à deux électrodes, la face E correspond à la face A et la face S correspond à la face B.

Cependant, il est tout à fait possible, dans le cas des cellules photovoltaïques intermédiaires (1<i<n) à deux électrodes que certaines ou la totalité d'entre elles soient disposées dans la configuration dans laquelle la face E correspond à la face A et la face S correspond à la face B.

Chaque cellule photovoltaïque est préparée sur un substrat indépendant.

Les substrats des cellules avant (i=1) et intermédiaires (1<i<n) sont transparents au rayonnement solaire pour permettre à celui-ci d'atteindre le matériau absorbant de chacune des cellules photovoltaïque de l'empilement. Ces substrats peuvent par exemple être entièrement en verre ou en polymère thermoplastique tel qu'un polyuréthane ou un polycarbonate ou un polyméthacrylate de méthyle. Ces substrats sont choisis pour présenter la meilleure transparence possible dans la partie du spectre utile à l'application du système photovoltaïque.

Il n'est pas nécessaire que le substrat de la cellule photovoltaïque arrière soit transparent. Ce substrat peut être, par exemple, en acier inoxydable, en verre, en polymère, en céramique ou en un composite de plusieurs de ces éléments.

### Préparation des substrats :

Le matériau utilisé comme substrat pour la préparation de cellule photovoltaïque i présente une stabilité à la fois thermique, chimique et mécanique qui est compatible avec l'ensemble des procédés de fabrication de la cellule photovoltaïque i à deux électrodes mais également aux procédés de fabrication de la cellule multi-électrode finales. Tous les substrats ont les mêmes dimensions.

### Préparation des cellules photovoltaïques sur les substrats :

On décrit brièvement la fabrication des cellules photovoltaïques avant, intermédiaires et arrière à deux électrodes, étant entendu que cette description s'applique à la fabrication de chaque cellule du dispositif photovoltaïque multi-électrode avant assemblage desdites cellules. La fabrication de chaque cellule photovoltaïque à deux électrodes composant la cellule photovoltaïque multi-électrode finale peut être mise en œuvre sur des lignes de production totalement indépendantes, que ce soit d'un point de vue des équipements utilisés ou d'un point de vue géographique. Chaque cellule peut être fabriquée par tout procédé existant, notamment par dépôts de couches minces sur un substrat.

Une première électrode à base d'oxyde transparent et conducteur est déposée sur le substrat. La couche d'oxyde transparent conducteur a typiquement une épaisseur de l'ordre de 0,05µm à 10µm, à base par exemple de d'oxyde d'étain dopé au fluor SnO₂:F, d'oxyde de zinc dopé à l'aluminium ZnO:Al, d'oxyde de zinc dopé au bore ZnO:B ou d'oxyde d'indium et d'étain (ITO). Elle est aussi transparente que possible, et présente une transmission la plus élevée possible du rayonnement solaire dans l'ensemble des longueurs d'onde correspondant au spectre d'absorption des matériaux constituant le matériau absorbant de la cellule photovoltaïque i et de l'ensemble des cellules photovoltaïques suivantes (de i+1 à n), afin de ne pas réduire le rendement de conversion global du module photovoltaïque multi-électrodes final. Cette couche d'oxyde transparent conducteur peut, par exemple, être déposée par pulvérisation cathodique, ou LPCVD (Low-Pressure Chemical Vapor Déposition), (Metallo-Organic Chemical Vapor Déposition) MOCVD.

Dans le cas de la cellule photovoltaïque arrière à deux électrodes (i=n), on peut également utiliser un réflecteur arrière qui peut être en aluminium (Al), en argent (Ag), en molybdène (Mo), en cuivre (Cu) ou en nitrure de titane (TiN) par exemple. Ce réflecteur arrière est déposé entre le substrat et la première électrode transparente conductrice. Ce dépôt d'un réflecteur arrière peut par exemple être effectué en utilisant une technologie de pulvérisation cathodique ou par pulvérisation cathodique réactive. Ce mode de réalisation convient particulièrement pour les applications dans lesquelles le module de cellules photovoltaïques est disposé sur le toit d'une habitation ou industriel car il permet de réfléchir la lumière vers l'extérieur.

Une texturation facultative de cette couche d'oxyde transparent conducteur, en utilisant par exemple une technologie de gravure plasma ou une texturation chimique par immersion dans une solution d'acide chlorhydrique HCl, peut ensuite être effectuée pour améliorer le confinement optique du rayonnement solaire et ainsi améliorer le rendement de conversion global du module photovoltaïque multi-électrode final.

Ensuite, le dépôt du matériau absorbant permettant la conversion photovoltaïque du rayonnement solaire est effectué en surface de la première électrode transparente conductrice. Il peut s'agir par exemple d'un absorbeur PIN ou NIP en silicium amorphe hydrogéné, d'un absorbeur en jonction PIN ou NIP en silicium polymorphe hydrogéné, d'un absorbeur en jonction PIN ou NIP en silicium microcristallin hydrogéné, d'un absorbeur en couches minces de type multi-jonctions telles qu'une jonction tandem dont la première jonction PIN est à base de silicium amorphe et la seconde jonction PIN est à base de silicium microcristallin, d'un absorbeur à base de tellurure de cadmium CdTe associé à une couche tampon en sulfure de cadmium CdS, d'un absorbeur à base de chalcopyrite comme par exemple l'alliage Cu(InₓGa₁₋ₓ)(Se,S)₂ avec x compris entre 0 et 1, associé à une couche tampon en sulfure de cadmium CdS ou en sulfure d'indium In₂S₃, d'un absorbeur à base d'un alliage amorphe de silicium et germanium SiₓGe₁₋ₓ hydrogéné, ou d'un absorbeur organique de type poly(3-hexylthiophene) et [6,6]-phényl-C61-butyrate de méthyle (P3HT/PCBM) par exemple.

De préférence, les matériaux utilisés pour la fabrication des jonctions ont des capacités d'absorption du rayonnement solaire différentes. Le matériau absorbant utilisé pour la cellule photovoltaïque i présente une transmission élevée dans l'ensemble des longueurs d'onde correspondant au spectre d'absorption des matériaux constituant le matériau absorbant des cellules photovoltaïques suivantes (de i+1 à n), afin de ne pas réduire le rendement de conversion global du module photovoltaïque multi-électrodes final. Par exemple, dans le cas d'une cellule à quatre électrodes (n=2), c'est-à-dire fabriquée à partir de deux cellules à deux électrodes indépendantes, on pourra choisir pour la cellule avant (i=1) un absorbeur en jonction PIN ou NIP en silicium amorphe hydrogéné et pour la cellule arrière (i=2) un absorbeur en jonction PIN ou NIP en silicium microcristallin hydrogéné.

Enfin, une seconde électrode transparente et conductrice est déposée à la surface de l'absorbeur. La couche d'oxyde transparent conducteur, à base par exemple de SnO₂:F, de ZnO:Al, de ZnO:B ou d'ITO, est aussi transparente que possible, et présente une transmission élevée du rayonnement solaire dans l'ensemble des longueurs d'onde correspondant au spectre d'absorption des matériaux constituant le matériau absorbant de la cellule photovoltaïque i et de l'ensemble des cellules photovoltaïques suivantes (de i+1 à n), afin de ne pas réduire le rendement de conversion global du module photovoltaïque multi-électrodes final.

De façon connue en soi, des étapes de segmentation des différentes couches minces en cellules par des gravures par laser, gravures mécaniques ou gravure par procédé « lift-off » par exemple ainsi que des étapes de lavage des différentes surfaces peuvent être prévues entre les étapes de dépôts afin de former un réseau de cellules photovoltaïques disposées en séries sur un même substrat. Ces étapes successives de segmentations des différentes couches minces permettent ainsi une association en série des différentes cellules formées à la surface du substrat lors des étapes de segmentation par une intégration monolithique. Des étapes de lavage des différentes surfaces peuvent être prévues entre les étapes de dépôts et de segmentation.

Une étape supplémentaire d'isolation électrique de la périphérie des couches peut également être effectuée sur la surface A du substrat. Cette isolation peut, par exemple, être effectuée par un procédé utilisant un laser.

Enfin, une bande de la totalité des dépôts effectués sur la surface A substrat est enlevée en périphérie du substrat afin de délimiter une zone exempte de tout dépôt. Cette élimination de toutes les couches en périphérie du substrat permet d'une part d'isoler les matériaux absorbants de l'environnement extérieur et, d'autre part, de permettre au feuillet d'intercalation d'être en contact direct avec le substrat en sa périphérie, permettant une meilleure isolation vis-à-vis de l'humidité et de l'oxygène. Typiquement, la bande éliminée en périphérie a une largeur comprise entre 10 mm et 15 mm.

Cette abrasion des couches en périphérie peut être effectuée par exemple par ablation laser ou par abrasion mécanique, en utilisant une méthode de sablage à l'aide d'une poudre de corindon par exemple ou à l'aide d'une roue abrasive.

### Câblage des cellules photovoltaïques :

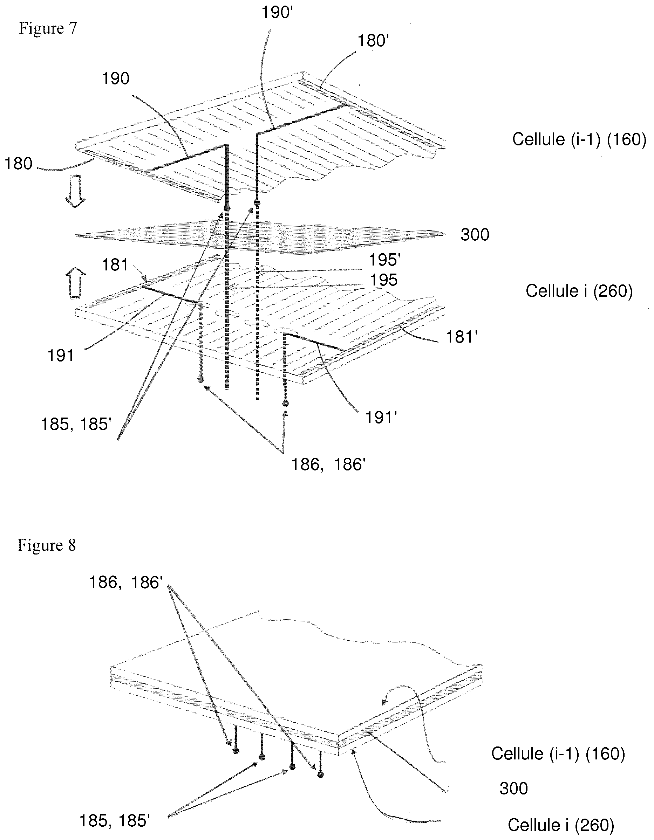

Pour l'architecture de cablâge électrique des cellules photovoltaïques, il est fait référence aux Figures 7-12. Sur la Figure 7, des bus de collecte de courant (180, 180', 181, 181') sont placés latéralement de part et d'autre d'une cellule i en intégration monolithique série pour permettre la collecte des électrons générés par cette cellule photovoltaïque. Les bus de collecte s'étendent sur les bordures latérales du substrat. Pour placer ces bus de collecte latéraux, on peut utiliser des équipements de soudure automatique ou bien effectuer ces connexions manuellement.

Deux bandes de connexion (190, 190', 191, 191') sont ensuite connectées à chaque bus de collecte. Chaque bande de connexion sert de liaison entre les deux bus de collecte électrique et les zones de contact extérieures au module. Les bandes de connexion s'étendent selon une direction perpendiculaire à la direction des bus de collecte de courant et sont chacune amenées vers le centre du substrat. La longueur de la portion de la bande de connexion s'étendant selon une direction perpendiculaire à la direction des bus de collecte de courant varie selon les cellules photovoltaïques selon le schéma de la figure 7. On constate en effet sur la figure 7 que la portion des bandes de connexion (191, 191') fixée à la cellule photovoltaïque (i) est plus courte que la portion des bandes de connexion (190, 190') fixée à la cellule photovoltaïque (i-1). Cette variation de longueur permet un décalage de la position des bornes de sortie de courant (185, 185', 186 et 186'). Ce décalage permet d'éviter que les bornes de sortie de courant des cellules photovoltaïques soient alignées les unes au-dessus des autres ce qui rendrait difficile la connexion ultérieure des bornes de sortie de courant à une boîte de connexion et pourrait engendrer un court-circuit entre ces bornes. Il est possible d'allonger les bandes de connexion (190, 190') de la cellule i-1 de façon à ce que celles-ci traversent la totalité des cellules allant de la cellule i à la cellule n et les feuillets d'encapsulant, jusqu'à dépasser en face arrière de la cellule photovoltaïque. Les rallonges de bande de connexion sont symbolisées par les références 195 et 195' sur la figure 7. La figure 8 représente le dispositif photovoltaïque multi-électrodes une fois assemblé.

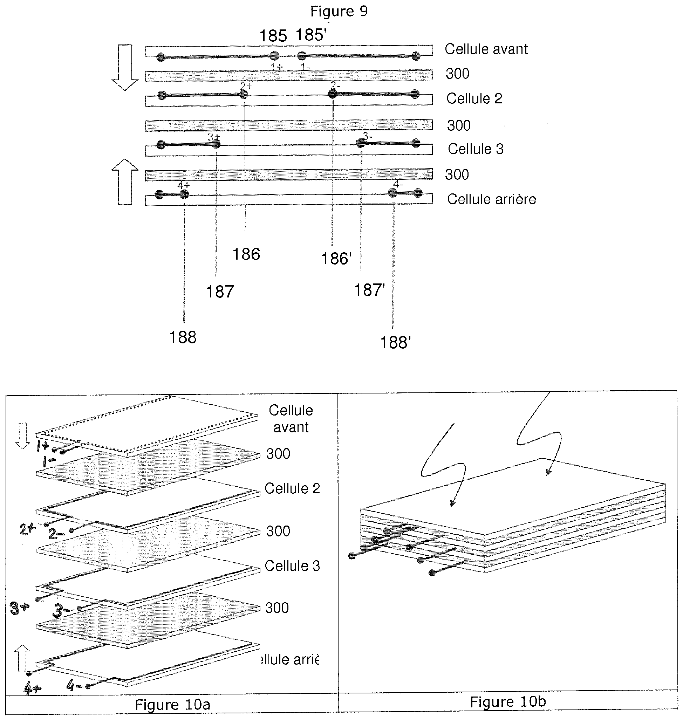

La Figure 9 montre sur un empilement de quatre cellules photovoltaïques que la longueur de la bande de connexion s'étendant selon une direction perpendiculaire à la direction des bus de collecte de courant diminue depuis la cellule photovoltaïque avant vers la cellule photovoltaïque arrière. Les longueurs des bandes de connexion s'étendant selon une direction perpendiculaire à la direction des bus de collecte de courant sont identiques pour les deux électrodes d'une même cellule photovoltaïque.

Il est nécessaire d'isoler électriquement les deux bandes de connexion de l'électrode située en face A du substrat. Pour cela, une bande de matériau isolant est placée entre la face A et les deux bandes de connexion.

Selon un mode de réalisation, les bornes de sortie de courant dépassent du substrat et s'étendent dans un plan parallèle au substrat. On parle alors d'une configuration avec « électrodes sur la tranche » (Figures 10a et 10b). Les bornes de sortie de courant de la cellule i sont rallongées de façon à ce qu'elles dépassent de la tranche (ou face latérale) des substrats et des feuillets d'encapsulant. Le dispositif constitué de l'empilement des cellules photovoltaïques a une forme parallélépipédique comprenant une face supérieure, une face inférieure et quatre faces latérales. La face supérieure est la face recevant la lumière. La configuration avec « électrodes sur la tranche » correspond à la sortie des bornes de sortie de courant sur une des faces latérales du dispositif photovoltaïque. Après assemblage des différents éléments du dispositif photovoltaïque, on constate que les bornes de sortie de courant (185, 186, 187, 188, 185', 186', 187' et 188') sont décalées les unes par rapport aux autres. On entend par « bornes de sortie de courant décalées » la caractéristique selon laquelle il n'existe pas deux bornes de sortie de courant qui soient situées sur un même plan perpendiculaire au plan formé par la face supérieure du dispositif photovoltaïque.

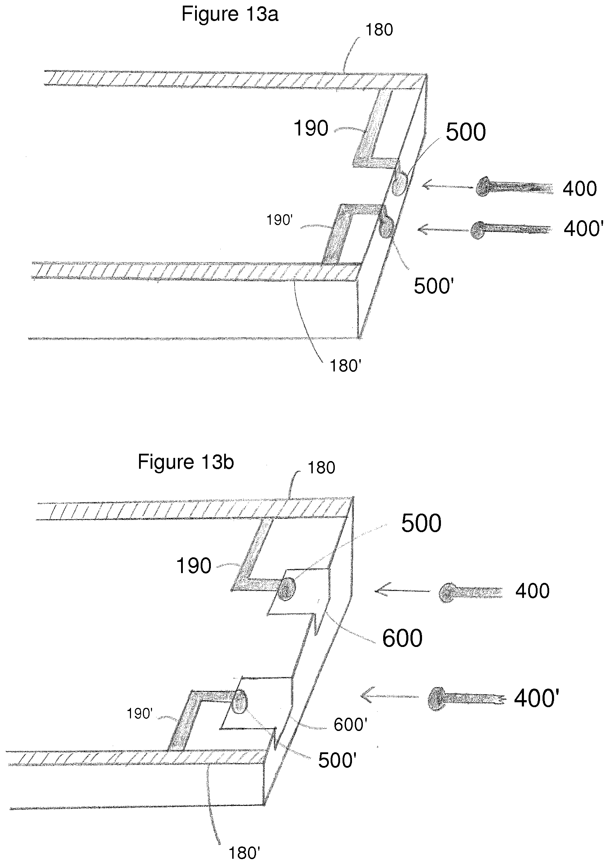

Dans un mode différent de réalisation dans lequel la connexion se fait toujours sur la tranche (ou face latérale) du dispositif photovoltaïque, il est possible de prévoir que des fiches (400, 400') viennent coopérer avec des contacts (500, 500') situés aux extrémités des bandes de connexion (Figures 13 a et 13b). Les contacts peuvent se situer soit sur la tranche (ou face latérale) de la cellule photovoltaïque, soit dans un logement (600, 600') situé sur la tranche (ou face latérale) de la cellule photovoltaïque.

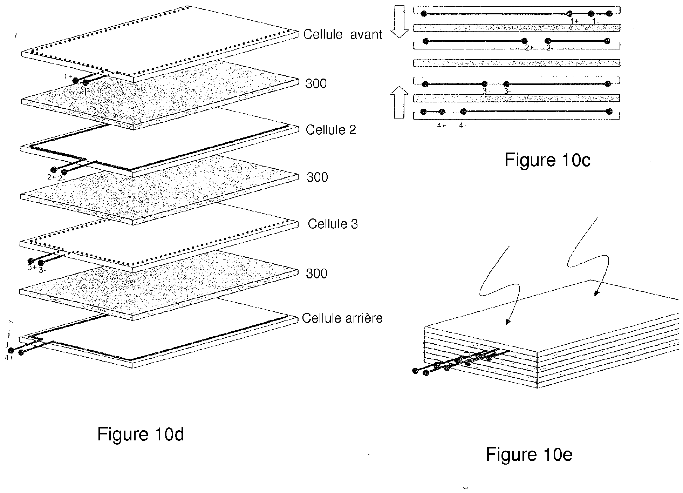

On peut également envisager un mode de réalisation tel que représenté aux Figures 10c, 10d et 10e, dans lequel les longueurs de bande de connexion s'étendant selon une direction perpendiculaire à la direction des bus de collecte de courant sont différentes pour les deux électrodes d'une même cellule photovoltaïque.

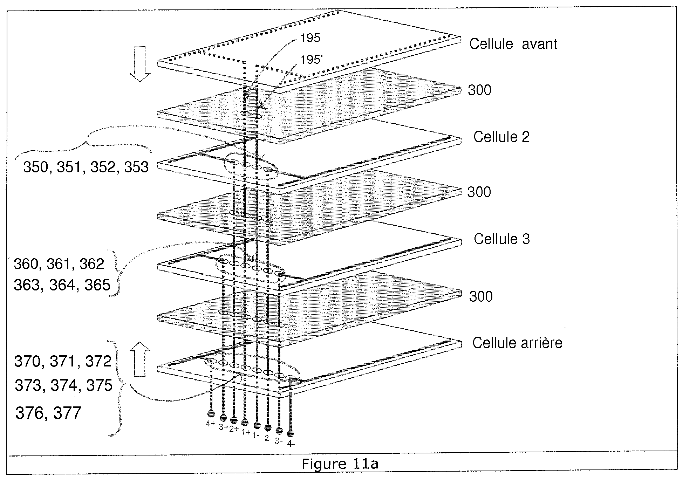

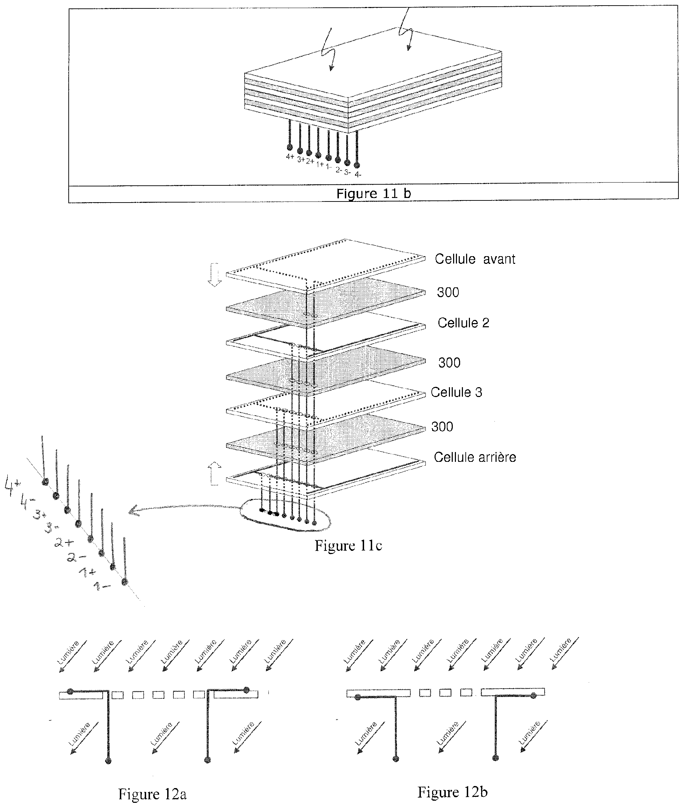

Selon un autre mode de réalisation, les bornes de sortie de courant dépassent du substrat et s'étendent dans un plan perpendiculaire au substrat. On parle alors d'une configuration avec « électrodes en face arrière» (Figures 11a, 11b et 11c). La configuration avec « électrodes sur la face arrière» correspond donc à la sortie des bornes de sortie de courant sur la face inférieure du dispositif photovoltaïque.

Dans le cas de la préparation d'une cellule photovoltaïque multi-jonctions et multi-électrodes dans laquelle les électrodes sont situées sur la tranche (ou face latérale) de la cellule, il n'est pas nécessaire d'effectuer une préparation préalable de perçage des substrats.

Dans le cas de la préparation d'une cellule photovoltaïque multi-jonctions et multi-électrodes dans laquelle les électrodes sont situées en face arrière de la cellule, il est nécessaire d'effectuer une préparation préalable des substrats. En effet, afin de permettre aux électrodes de chaque cellule photovoltaïque à deux électrodes indépendantes d'arriver en face arrière du module, les substrats i=2 à n doivent être percés de trous pour le passage des bornes de sortie de courant (Figure 11a). La cellule 2 comprend 4 trous (350, 351, 352, 353). La cellule 3 comprend 6 trous (360, 361, 362, 363). La cellule arrière comprend 8 trous (370, 371, 372, 373, 374, 375, 376, 377). Pour une cellule donnée, la présence des 2 trous situés à chacune des extémités de la rangée de trous est facultative. En effet, ces deux trous peuvent être absents s'il est prévu que les bandes de connexion soient placées sur la face inférieure de la cellule photovoltaïque. Par contre, leur présence est nécessaire, s'il est prévu que les bandes de connexion soient placées sur la face supérieure de la cellule photovoltaïque. Le substrat de la cellule avant (i=1) ne comporte quant à lui aucun trou de perçage. Celui-ci sert en effet de couvercle à la cellule photovoltaïque multi-électrodes finale. D'autre part, les extrémités intérieures des bandes de connexion de la cellule i coïncident avec les trous présents dans le feuillet d'encapsulant i (Fig.11a). Il est possible d'allonger les bandes de connexion de la cellule i de façon à ce que la bande de connexion traverse la totalité des substrats et des feuillets d'encapsulant jusqu'à dépasser en face arrière de la cellule photovoltaïque multi-électrodes comme cela a été expliqué pour la Figure 7.

Il est important de veiller dans le cas de l'utilisation derallonges des bandes de connexion (195, 195') que ces rallonges ressortent sur la face S du substrat. Dans ce cas, il faut veiller à ce que dans le cas où la cellule photovoltaïque intermédiaire i (1<i<n) à deux électrodes est placée dans l'empilement de façon à ce que la face E corresponde à la face A et la face S corresponde à la face B, les rallonges des bandes de connexion de la cellule photovoltaïque i passent au travers des trous percés dans le substrat i et prévus à cet effet (Fig. 12a).

Dans le cas où la cellule photovoltaïque intermédiaire i (1<i<n) à deux électrodes est placée dans l'empilement de façon à ce que la face E corresponde à la face B et la face S à la face A, les rallonges des bandes de connexion de la cellule photovoltaïque i ne passent pas par les trous du substrat i (Fig.12b).

Dans le cas où la cellule photovoltaïque intermédiaire i (1<i<n) à deux électrodes est placée dans l'empilement de façon à ce que la face E corresponde à la face B et la face S corresponde à la face A, le substrat i supportant la cellule photovoltaïque i comprendra 2i trous préalablement percés sur une ligne parallèle à un des bords du substrat. Pour ce substrat, les 2(i-1) trous centraux coïncident avec les trous percés dans l'encapsulant (i-1). Ce substrat peut comprendre deux trous supplémentaires de part et d'autre de ces trous.

Dans le cas où la cellule photovoltaïque intermédiaire i (1<i<n) à deux électrodes est placée dans l'empilement de façon à ce que la face E corresponde à la face A et la face S corresponde à la face B, le substrat i supportant la cellule photovoltaïque i comprendra 2(i-1) trous percés sur une ligne parallèle à un des bords du substrat. Pour ce substrat, ces 2(i-1) trous centraux coïncident avec les trous percés dans l'encapsulant i.

Le substrat de la cellule arrière (i=n) comprendra 2n trous percés sur une ligne parallèle à un des bords du substrat. Pour ce substrat, les 2(n-1) trous centraux correspondent avec les trous percés dans l'encapsulant (n-1). Le substrat peut aussi comprendre deux trous supplémentaires de part et d'autre de ces trous.

Pour ne pas réduire le rendement de conversion global du module photovoltaïque multi-électrode final, il est préférable de faire coïncider l'emplacement des bus de collecte et des bornes de sortie de courant de chacune des cellules.

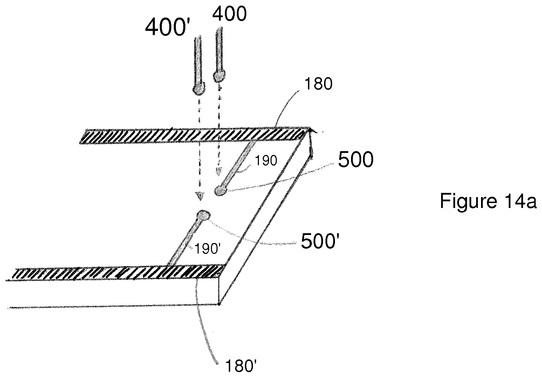

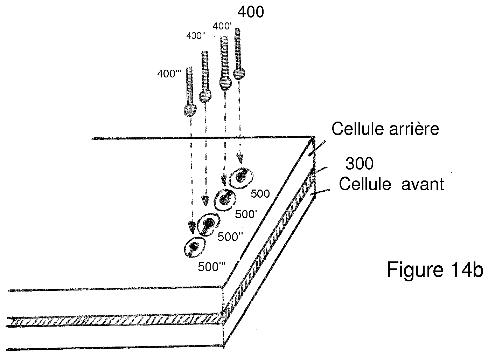

Selon l'invention, il est possible de ne pas utiliser des rallonges de bande de connexion. La connexion électrique entre chaque cellule photovoltaique et le boîtier de connexion est alors rendue possible grâce à l'utilisation de fiches de longueurs différentes (400, 400') qui coopèrent avec des contacts (500, 500') disposés en face arrière de la cellule photovoltaïque. (Figures 14a) et 14b)).

Le placement et la soudure des différents bus de collecte et des bandes de connexion peut se faire manuellement. Mais typiquement, ceci se fait à l'aide d'un système automatisé. Les bus de collecte électriques et les bornes de sortie de courant peuvent être des bandes métalliques telles que des rubans d'argent recouverts de nickel, des rubans de nickel recouverts d'argent, des cordons d'étain, des rubans de cuivre recouvert d'étain, des rubans d'étain recouverts de cuivre ou tout autre matériau permettant de transporter le courant généré par la cellule photovoltaïque et qui puisse être soudé aux électrodes de la cellule photovoltaïque.

### Choix des intercalaires de feuilletage :

Une fois chacune des cellules photovoltaïques avant, intermédiaires et arrière fabriquées de façon indépendante, elles sont assemblées les unes aux autres par l'intermédiaire d'un intercalaire de feuilletage (encapsulant).

L'intermédiaire de feuilletage choisi pour l'assemblage des cellules à deux électrodes en une cellule multi-jonctions et multi-électrodes a pour but de:
- Permettre une protection mécanique,
- Jouer le rôle de barrière contre la vapeur d'eau et l'oxygène,
- Permettre une isolation électrique,
- Permettre une absorption de chocs,
- Ne pas être une source de corrosion des matériaux de la cellule,
- Présenter des propriétés adhésives.

Le choix peut par exemple se faire parmi les élastomères comme par exemple l'éthylène-acétate de vinyle (EVA), les résines polyuréthanes (RPU), les résines polyacrylates ou les silicones et les thermoplastiques comme par exemple le polyvinyle butyral (PVB), les thermoplastiques polyuréthanes (TPU), certaines polyoléfines modifiées (EPDM, DMP). D'autres produits d'intermédiaire de feuilletage peuvent être utilisés avec l'EVA ou à la place de celui-ci, par exemple une matière plastique du type Tedlar®, une matière plastique du type Nuvasil®, une matière plastique du type Tefzel®, ou des revêtements durcissables par l'intermédiaire d'ultraviolets, ainsi que des combinaisons de ceux-ci.

L'intercalaire de feuilletage est aussi transparent que possible et présente une transmission élevée du rayonnement solaire dans l'ensemble des longueurs d'onde correspondant au spectre d'absorption des matériaux constituant le matériau absorbant de la cellule photovoltaïque i et de l'ensemble des cellules photovoltaïques suivantes (de i+1 à n), afin de ne pas réduire le rendement du module photovoltaïque.

### Préparation des feuillets d'encapsulant :

Tous les feuillets d'encapsulant ont les mêmes dimensions que les substrats.

Dans le cas de la préparation d'une cellule photovoltaïque multi-jonctions et multi-électrodes dans laquelle les électrodes sont situées sur la tranche (ou face latérale) de la cellule, il n'est pas nécessaire d'effectuer une préparation préalable des feuillets d'encapsulant (Figures 10a et b).

Dans le cas de la préparation d'une cellule photovoltaïque multi-jonctions et multi-électrodes dans laquelle les électrodes sont situées en face arrière de la cellule, il est nécessaire d'effectuer une préparation préalable des feuillets d'encapsulant. En effet, afin de permettre aux électrodes de chaque cellule photovoltaïque à deux électrodes indépendantes d'arriver en face arrière du module, les feuillets d'encapsulant i=1 à (n-1) sont percés de trous. (Figure 11a, 11b, 11c).

De manière générale, l'encapsulant i se trouvant entre le substrat de la cellule i et le substrat de la cellule (i+1) comprendra 2i trous préalablement percés sur une ligne parallèle à un des bords du substrat. Pour ce substrat, les 2(i-1) trous centraux coïncident avec les trous percés dans le substrat i.

Un joint ou une résine d'étanchéité pourra également être placé entre chaque substrat, soit en périphérie de la face S du substrat i, soit en périphérie de la face E du substrat (i+1), pour permettre une étanchéité supplémentaire entre les substrats i et (i+1), notamment vis-à-vis de l'humidité. Ce joint ou cette résine d'étanchéité peut être par exemple un polymère thermofusible comme l'éthylène-vinylacétate, le polyisobutylène ou un mastic à base, par exemple de polyuréthane, de polysulfure ou de silicone.

Les joints de soudure au niveau des trous du substrat arrière peuvent ensuite également être enrobés d'époxy, par exemple, en vue d'une protection supplémentaire vis-à-vis de l'environnement.

### Assemblage de la cellule photovoltaïque multi-ionctions et multi-électrode à partir des cellules photovoltaïques indépendantes à deux électrodes et des intercalaires de feuilletage :

Les différentes cellules photovoltaïques à deux électrodes sont assemblées les unes aux autres. Pour cela on place en surface de la face S de la cellule photovoltaïque 1 l'intercalaire de feuilletage 1. La face E de la cellule 2 est ensuite placée sur l'intercalaire de feuilletage 1. De manière générale, pour l'assemblage des cellules photovoltaïques, on dépose en surface de la face S de la cellule photovoltaïque i, l'intercalaire de feuilletage i. Pour terminer, la face E de la cellule photovoltaïque n est placée en surface de l'intercalaire de feuilletage (n-1).

Lors de cette étape d'assemblage des différentes cellules photovoltaïques à deux électrodes, dans le cas de la préparation d'une cellule photovoltaïque multi-jonctions et multi-électrodes dans laquelle les électrodes sont situées en face arrière de la cellule, il est nécessaire lors du placement de l'intercalaire de feuilletage i, de veiller à faire coïncider les trous effectués dans l'intercalaire de feuilletage i avec les extrémités intérieures des bandes de connexion des i cellules précédentes. De même, lors du placement de la cellule i, il est important de veiller à faire coïncider les trous de l'intercalaire (i-1) avec les trous du substrat i.

Dans le cas d'une cellule multi-électrodes dans laquelle les électrodes sont situées en face arrière de la cellule et utilisant des rallonges des bandes de connexion il faut veiller à faire passer les rallonges des bandes de connexion des i-1 cellules précédentes au travers des trous de l'intercalaire de feuilletage i coïncidant et de faire passer les deux rallonges des bandes de connexion de la cellule photovoltaïque i au travers deux trous libres de l'intercalaire de feuilletage i. De même, lors du placement de la cellule i, il est important de veiller à faire coïncider les trous de l'intercalaire (i-1) avec les trous du substrat i (Figure 11a).

Dans le cas d'une cellule multi-électrodes dans laquelle les contacts se font au niveau de la tranche (ou face latérale) de la cellule, il est important de veiller à ce que les bandes de connexion des deux électrodes de la cellule photovoltaïque i, qui sont situées sur la tranche (ou face latérale) du substrat i, ne soient pas disposées exactement au dessus des bandes de connexion des électrodes des (i-1) cellules photovoltaïques précédentes (Figure 10b).

Lors ce cette étape d'assemblage des différentes parties de la cellule photovoltaïque multi-jonctions et multi-électrodes, il est nécessaire de veiller à chaque étape au bon alignement des substrats et des intercalaires de feuilletage entre eux. Cet alignement peut être effectué manuellement par des opérateurs ou automatiquement à l'aide d'un contrôle d'image par exemple et l'utilisation de robots permettant l'alignement.

L'ensemble comprenant l'empilement de n cellules photovoltaïques à deux électrodes et les (n-1) feuillets d'intercalation est ensuite placé dans un système de laminage qui va permettre de finaliser l'assemblage de la cellule photovoltaïque multi-jonctions et multi-électrodes. Ce laminage final peut être effectué par exemple dans un système de laminage sous vide ou dans un système de laminage par rouleau suivi d'un procédé en autoclave.

Le module de cellules photovoltaïques ainsi obtenu peut être connecté à un ou plusieurs boîtiers de connexion par l'intermédiaire des bornes de sortie de courant qui se trouvent toutes du même côté du module ou sur sa tranche. Le boîtier de connexion assure la connexion électrique du module à une interface utilisateur, généralement constituée par un dispositif électronique permettant de convertir une tension continue en une tension alternative compatible avec le réseau de distribution. De préférence, le module est connecté à un seul boîtier de connexion. De préférence, l'unique boîtier de connexion est installé dans l'encadrement du panneau servant de support au module de cellules photovoltaïques pour les modules à électrodes sur la face latérale et sur la face S de la cellule arrière pour les modules à électrodes sur la face arrière.

## Revendications

1. Dispositif photovoltaïque comprenant :
- un assemblage comprenant n cellules photovoltaïques (160, 260), n étant supérieur ou égal à 2,
- un matériau intercalaire de feuilletage (300) disposé entre chaque cellule photovoltaïque, chaque cellule photovoltaïque comprenant :
- deux bornes de sortie de courant (185, 185'),
- au moins une jonction photovoltaïque (150, 250),
- des bus de collecte de courant (180, 180'), et
- des bandes de connexion (190, 190') qui s'étendent depuis les bus de collecte de courant jusqu'aux bornes de sortie de courant,
le dispositif étant de forme parallélépipédique et toutes les bornes de sortie de courant étant disposées sur la face inférieure du parallélépipède du dispositif photovoltaïque,
dans lequel les bornes de sortie de courant sont des contacts (500, 500') aux extrémités des bandes de connexion (190, 190') et configurées pour être connectées à un boîtier de connexion via des fiches (400, 400') de longueurs différentes du boîtier de connexion,
et dans lequel le dispositif comprend :
- une cellule photovoltaïque avant,
- au moins une cellule photovoltaïque intermédiaire i, avec 1<i<n, si n strictement supérieur à 2,
- une cellule photovoltaïque arrière n,
chaque cellule photovoltaïque intermédiaire i comportant 2(i-1) trous (351, 352) pour permettre aux contacts des cellules photovoltaïques 1 à (i-1) d'être aptes à coïncider avec des fiches du boîtier de connexion et éventuellement deux trous (350, 353) pour permettre aux contacts de la cellule photovoltaïque i d'être aptes à coïncider avec des fiches du boîtier de connexion, la cellule photovoltaïque arrière n comportant 2(n-1) trous (371-376) pour permettre aux contacts des cellules photovoltaïques 1 à (n-1) d'être aptes à coïncider avec des fiches du boîtier de connexion et éventuellement deux trous supplémentaires (370, 377) pour permettre aux contacts de la cellule photovoltaïque n d'être aptes à coïncider avec des fiches du boîtier de connexion.

2. Dispositif selon la revendication 1, dans lequel la cellule photovoltaïque arrière comprend une couche d'un matériau réflecteur de lumière (230).

3. Dispositif selon la revendication 1, dans lequel la cellule photovoltaïque arrière ne comprend pas de couche d'un matériau réflecteur de lumière.

4. Dispositif selon l'une des revendications précédentes, dans lequel le matériau de jonction photovoltaïque est choisi dans le groupe comprenant le silicium micro cristallin, le silicium polymorphe, le silicium amorphe, le groupe du tellure de cadmium CdTe associé à une couche tampon en sulfure de cadmium CdS, le groupe des chalcopyrites CuIn_{l_x}Gaₓ(Se,S)₂, x compris entre 0 et 1, associé à une couche tampon en sulfure de cadmium CdS ou en sulfure d'indium In₂S₃, le groupe des alliages amorphes de silicium et germanium SiₓGe_{l_x} hydrogénés, le groupe des matériaux organiques à base de poly(3- hexylthiophene) et [6,6]-phényl-C61-butyrate de méthyle, ou un mélange de ceux-ci.

5. Dispositif selon l'une des revendications précédentes dans lequel une électrode constituée d'un oxyde conducteur transparent (TCO) est présente par face de la j onction.

6. Ensemble photovoltaïque comprenant :
- un dispositif selon l'une des revendications 1 à 5,
- le boîtier de connexion.

7. Ensemble photovoltaïque selon la revendication 6 dans lequel les bornes de sortie de courant du dispositif sont regroupées dans le boîtier de connexion en formant un premier groupe constitué des bornes de sortie de courant positives et en formant un second groupe constitué des bornes de sortie de courant négatives.

8. Procédé de fabrication d'un dispositif photovoltaïque selon l'une des revendications 1 à 5 comprenant le laminage des cellules photovoltaïques (160, 260) et des matériaux intercalaires de feuilletage (300).

9. Procédé selon la revendication 8 comprenant les étapes d'empilement :
- de la cellule photovoltaïque avant,
- du matériau intercalaire de feuilletage troué, les trous étant en regard des bornes de sortie de courant de la cellule photovoltaïque avant sur laquelle est déposé le matériau intercalaire de feuilletage,
- de la, au moins une, cellule photovoltaïque intermédiaire i comportant 2(i-1) trous (351, 352) pour permettre aux contacts des cellules photovoltaïques 1 à (i-1) d'être aptes à coïncider avec des fiches du boîtier de connexion et éventuellement deux trous (350, 353) pour permettre aux contacts de la cellule photovoltaïque i d'être aptes à coïncider avec des fiches du boîtier de connexion,
- du matériau intercalaire de feuilletage troué, les trous étant en regard des bornes de sortie de courant de la cellule photovoltaïque i sur laquelle est déposé le matériau intercalaire de feuilletage,
- de la cellule photovoltaïque arrière n comportant 2(n-1) trous (371-376) pour permettre aux contacts des cellules photovoltaïques 1 à (n-1) d'être aptes à coïncider avec des fiches du boîtier de connexion et éventuellement deux trous supplémentaires (370, 377) pour permettre aux contacts de la cellule photovoltaïque n d'être aptes à coïncider avec des fiches du boîtier de connexion,
- laminage de l'empilement, le laminage pouvant être réalisé par opérations séquentielles après dépôt de chaque cellule ou de matériau intercalaire ou pouvant être réalisé lors d'une seule étape après assemblage des cellules et des matériaux intercalaires.

## Patentansprüche

1. Photovoltaikvorrichtung, welche umfasst:
- eine Anordnung, die n Photovoltaikzellen (160, 260) umfasst, wobei n größer oder gleich 2 ist,
- ein Laminierungszwischenschicht-Material (300), das jeweils zwischen den Photovoltaikzellen angeordnet ist, wobei jede Photovoltaikzelle umfasst:
- zwei Stromausgangsanschlüsse (185, 185'),
- wenigstens einen photovoltaischen Übergang (150, 250),
- Stromsammelschienen (180, 180') und
- Verbindungsbänder (190, 190'), welche sich von den Stromsammelschienen bis zu den Stromausgangsanschlüssen erstrecken,
wobei die Vorrichtung quaderförmig ist und alle Stromausgangsanschlüsse auf der Unterseite des Quaders der Photovoltaikvorrichtung angeordnet sind,
wobei die Stromausgangsanschlüsse Kontakte (500, 500') an den Enden der Verbindungsbänder (190, 190') sind und dafür ausgelegt sind, mit einem Anschlussgehäuse über Kontaktstifte (400, 400') mit unterschiedlichen Längen des Anschlussgehäuses verbunden zu werden,
und wobei die Vorrichtung umfasst:
- eine vordere Photovoltaikzelle,
- wenigstens eine Zwischen-Photovoltaikzelle i, mit 1<i<n, falls n streng größer als 2 ist,
- eine hintere Photovoltaikzelle n,
wobei jede Zwischen-Photovoltaikzelle i 2(i-1) Löcher (351, 352), um zu ermöglichen, dass die Kontakte der Photovoltaikzellen 1 bis (i-1) mit Kontaktstiften des Anschlussgehäuses übereinstimmen können, und eventuell zwei Löcher (350, 353), um zu ermöglichen, dass die Kontakte der Photovoltaikzelle i mit Kontaktstiften des Anschlussgehäuses übereinstimmen können, aufweist, wobei die hintere Photovoltaikzelle n 2(n-1) Löcher (371-376), um zu ermöglichen, dass die Kontakte der Photovoltaikzellen 1 bis (n-1) mit Kontaktstiften des Anschlussgehäuses übereinstimmen können, und eventuell zwei zusätzliche Löcher (370, 377), um zu ermöglichen,
dass die Kontakte der Photovoltaikzelle n mit Kontaktstiften des Anschlussgehäuses übereinstimmen können, aufweist.

2. Vorrichtung nach Anspruch 1, wobei die hintere Photovoltaikzelle eine Schicht aus einem lichtreflektierenden Material (230) umfasst.

3. Vorrichtung nach Anspruch 1, wobei die hintere Photovoltaikzelle keine Schicht aus einem lichtreflektierenden Material umfasst.

4. Vorrichtung nach einem der vorhergehenden Ansprüche, wobei das Material des photovoltaischen Übergangs ausgewählt ist aus der Gruppe, die mikrokristallines Silizium, polymorphes Silizium, amorphes Silizium umfasst, der Gruppe von Cadmiumtellurid CdTe in Verbindung mit einer Pufferschicht aus Cadmiumsulfid CdS, der Gruppe der Chalkopyrite CuIn₁₋ₓGaₓ(Se,S)₂, mit x zwischen 0 und 1, in Verbindung mit einer Pufferschicht aus Cadmiumsulfid CdS oder aus Indiumsulfid In₂S₃, der Gruppe der hydrierten amorphen Legierungen von Silizium und Germanium SiₓGe₁₋ₓ, der Gruppe der organischen Materialien auf der Basis von Poly(3-hexylthiophen) und [6,6]-Phenyl-C61-methylbutyrat, oder einer Mischung davon.

5. Vorrichtung nach einem der vorhergehenden Ansprüche, wobei je eine Elektrode, die aus einem transparenten, elektrisch leitfähigen Oxid (TCO) besteht, auf jeder Seite des Übergangs vorhanden ist.

6. Photovoltaikanordnung, welche umfasst:
- eine Vorrichtung nach einem der Ansprüche 1 bis 5,
- das Anschlussgehäuse.

7. Photovoltaikanordnung nach Anspruch 6, wobei die Stromausgangsanschlüsse der Vorrichtung im Anschlussgehäuse in Gruppen zusammengefasst sind, wobei sie eine erste Gruppe bilden, die aus den positiven Stromausgangsanschlüssen besteht, und wobei sie eine zweite Gruppe bilden, die aus den negativen Stromausgangsanschlüssen besteht.

8. Verfahren zur Herstellung einer Photovoltaikvorrichtung nach einem der Ansprüche 1 bis 5, welches das Laminieren der Photovoltaikzellen (160, 260) und der Laminierungszwischenschicht-Materialien (300) umfasst.

9. Verfahren nach Anspruch 8, welches die Schritte des Stapelns umfasst:
- der vorderen Photovoltaikzelle,
- des mit Löchern versehenen Laminierungszwischenschicht-Materials, wobei sich die Löcher gegenüber den Stromausgangsanschlüssen der vorderen Photovoltaikzelle befinden, auf welche das Laminierungszwischenschicht-Material abgelagert wird,
- der wenigstens einen Zwischen-Photovoltaikzelle i, die 2(i-1) Löcher (351, 352), um zu ermöglichen, dass die Kontakte der Photovoltaikzellen 1 bis (i-1) mit Kontaktstiften des Anschlussgehäuses übereinstimmen können, und eventuell zwei Löcher (350, 353), um zu ermöglichen, dass die Kontakte der Photovoltaikzelle i mit Kontaktstiften des Anschlussgehäuses übereinstimmen können, aufweist,
- des mit Löchern versehenen Laminierungszwischenschicht-Materials, wobei sich die Löcher gegenüber den Stromausgangsanschlüssen der Photovoltaikzelle i befinden, auf welche das Laminierungszwischenschicht-Material abgelagert wird,
- der hinteren Photovoltaikzelle n, die 2(n-1) Löcher (371-376), um zu ermöglichen, dass die Kontakte der Photovoltaikzellen 1 bis (n-1) mit Kontaktstiften des Anschlussgehäuses übereinstimmen können, und eventuell zwei zusätzliche Löcher (370, 377), um zu ermöglichen, dass die Kontakte der Photovoltaikzelle n mit Kontaktstiften des Anschlussgehäuses übereinstimmen können, aufweist,
- Laminieren des Stapels, wobei das Laminieren durch aufeinander folgende Arbeitsgänge nach Ablagerung jeder Zelle oder jedes Zwischenschichtmaterials durchgeführt werden kann oder in einem einzigen Schritt nach dem Zusammenfügen der Zellen und der Zwischenschichtmaterialien durchgeführt werden kann.

## Claims

1. Photovoltaic device comprising:
- an assembly comprising n photovoltaic cells (160, 260), n being higher than or equal to 2,
- a lamination interlayer (300) placed between each photovoltaic cell, each photovoltaic cell comprising:
o two current output terminals (185, 185'),
o at least one photovoltaic junction (150, 250),
o current-collecting buses (180, 180'), and
o connecting strips (190, 190') that extend from the current-collecting buses to the current output terminals,
the device being parallelepiped shaped and all the current output terminals being placed on the lower face of the parallelepiped of the photovoltaic device,
wherein the current output terminals are contacts (500, 500') at the ends of the connecting strips (190, 190') and configured to be connected to a junction box via plugs (400, 400') of different lengths of the junction box, and wherein the device comprises:
- a front photovoltaic cell,
- at least one intermediate photovoltaic cell i, with 1<i<n, if n is strictly greater than 2,
- a back photovoltaic cell n,
each intermediate photovoltaic cell i comprising 2(i-1) apertures (351, 352) in order to allow the contacts of the photovoltaic cells 1 to (i-1) to be able to coincide with the plugs of the junction box and optionally two apertures (350, 353) in order to allow the contacts of the photovoltaic cell i to be able to coincide with the plugs of the junction box, the back photovoltaic cell n comprising 2(n-1) apertures (371-376) in order to allow the contacts of the photovoltaic cells 1 to (n-1) to be able to coincide with the plugs of the junction box and optionally two additional apertures (370, 377) in order to allow the contacts of the photovoltaic cell n to be able to coincide with the plugs of the junction box.

2. Device according to Claim 1, wherein the back photovoltaic cell comprises a layer (230) of a material that reflects light.

3. Device according to Claim 1, wherein the back photovoltaic cell does not comprise a layer of a material that reflects light.

4. Device according to any one of the preceding claims, wherein the photovoltaic junction material is chosen from the group comprising: microcrystalline silicon; polymorphous silicon; amorphous silicon; the group of cadmium telluride CdTe associated with a buffer layer made of cadmium sulfide CdS; the group of the chalcopyrites CuIn₁₋ₓGaₓ (Se, S)₂, where x lies between 0 and 1, associated with a buffer layer made of cadmium sulfide CdS or indium sulfide In₂S₃; the group of hydrogenated, amorphous alloys of silicon and germanium SiₓGe₁₋ₓ; and the group of organic materials based on poly(3-hexylthiophene) and [6,6]-phenyl-C61-butyric acid methyl; and mixtures of the above.

5. Device according to any one of the preceding claims, wherein one electrode made of a transparent conductive oxide (TCO) is present per face of the junction.

6. Photovoltaic assembly comprising:
- a device according to one of claims 1 to 5,
- the junction box.

7. Photovoltaic assembly according to Claim 6, wherein the output terminals of the device are grouped in the junction box such as to form a first group made up of the positive current output terminals and a second group made up of the negative current output terminals.

8. Method for manufacturing a photovoltaic device according to one of Claims 1 to 5, comprising laminating photovoltaic cells (160, 260) and lamination interlayers (300).

9. Method according to Claim 8, comprising steps of stacking:
- the front photovoltaic cell,
- the apertured lamination interlayer, the apertures facing the current output terminals of the front photovoltaic cell, on which the lamination interlayer is deposited,
- the, at least one, intermediate photovoltaic cell i comprising 2(i-1) apertures (351, 352) in order to allow the contacts of the photovoltaic cells 1 to (i-1) to be able to coincide with the plugs of the junction box and optionally two apertures (350, 353) in order to allow the contacts of the photovoltaic cell i to be able to coincide with the plugs of the junction box,
- the apertured lamination interlayer, the apertures facing the current output terminals of the photovoltaic cell i, on which the lamination interlayer is deposited,
- the back photovoltaic cell n comprising 2(n-1) apertures (371-376) in order to allow the contacts of the photovoltaic cells 1 to (n-1) to be able to coincide with the plugs of the junction box and optionally two additional apertures (370, 377) in order to allow the contacts of the photovoltaic cell n to be able to coincide with the plugs of the junction box,
- laminating the stack, the lamination possibly being obtained via sequential operations after each cell or each interlayer has been deposited, or possibly being obtained in a single step after the cells and the interlayers have been assembled.
